# EUROPÄISCHE PATENTSCHRIFT

(11) **EP 1 921 687 B1**
(45) Veröffentlichungstag und Bekanntmachung des Hinweises auf die Patenterteilung: **28.10.2009**
(21) Anmeldenummer: 06023289.9
(22) Anmeldetag: 09.11.2006
(51) Int. Cl.: H01L 41/22

(54) **Verfahren und Vorrichtung zur Herstellung von Piezowandlern**
Process and apparatus for the fabrication of a piezoelectric transducer
Procédé et dispositif pour la fabrication d'un transducteur piézoéléctrique

(43) Veröffentlichungstag der Anmeldung: 14.05.2008
(73) Patentinhaber: FESTO AG & Co. KG, 73734 Esslingen (DE)
(72) Erfinder: Schmid, Andreas Joseph, Dr.-Ing., 96450 Coburg (DE); Weinmann, Michael, Dr.-Ing., 73655 Plüderhausen (DE)
(74) Vertreter: Vogler, Bernd

(56) Entgegenhaltungen:
- EP-A2- 0 289 278
- US-A1- 2006 164 466

## Beschreibung

Die Erfindung betrifft ein Verfahren und eine Vorrichtung zur Herstellung von Piezowandlern.

Herstellungsverfahren für Piezowandler lassen sich grob in drei verschiedene Prozessschritte unterteilen, nämlich Laminieren, Beschichten und Vereinzeln.

Beim Laminieren wird ein plattenartiger, mit Anschlusselementen aus elektrisch leitfähigem Material versehene Kontaktierungseinheit und mehrere an die Kontaktierungseinheit angrenzende Piezoschichten aus piezoelektrischem Material mit einer Tragkörper-Ausgangsstruktur, die auch als sogenannter Tragkörper-Prepreg bezeichnet wird, zu einem Piezo-Laminat zusammengefügt. Der Laminierprozess wird unter definiertem Druck und unter definierter Temperatur durchgeführt, wodurch die einzelnen Schichten sozusagen "zusammengebacken" werden.

Nach dem Laminieren erfolgt der Beschichtungsprozess, wobei vorzugsweise in mehreren Beschichtungsschritten unterschiedliche Funktionsschichten aufgebracht werden. Das Beschichten wird üblicherweise mittels Siebdruck oder Sputtern durchgeführt. Von den Funktionsschichten ist wenigstens eine eine auf den Piezoschichten aufzubringende Elektrodenschicht aus leitfähigem Material. Üblicherweise werden noch Dielektrika, also Schichten aus elektrisch nicht leitfähigem Material, aufgebracht, beispielsweise um zwischen den Schichten vorhandene Spalte o. dgl. aufzufüllen.

Nach dem Beschichtungsvorgang entsteht ein sogenannter Piezo-Nutzen, der anschließend zu einzelnen Piezowandlern vereinzelt wird.

Bei der Herstellung der Piezowandler ist eine hohe Maßgenauigkeit wichtig, das heißt die einzelnen Schichten müssen lagegenau positioniert werden. Insbesondere im Bereich der Anschlüsse ist eine sehr hohe Maßgenauigkeit gefordert, damit die Elektroden zuverlässig kontaktiert werden. Bei jedem der zuvor beschriebenen Prozessschritte treten Toleranzen hinsichtlich Lage und Position der einzelnen Bauteile bzw. Schichten auf. Die Einhaltung einer zulässigen Maximaltoleranz ist sehr wichtig und wird kontrolliert, beispielsweise wird am Piezo-Nutzen am Ende des Beschichtungsvorgangs eine Qualitätskontrolle durchgeführt. Wird die Maximaltoleranz überschritten, so sind einzelne Bereiche des Piezo-Nutzens oder gar das gesamte Piezo-Nutzen-Bauteil fehlerhaft und gegebenenfalls Ausschuss. Es ist bekannt, Bauelemente bzw. Schichten mit Bezug zu äußeren Kanten des späteren Piezo-Nutzens aufzubauen. Hieraus resultiert die ungünstige Aufaddierung der Toleranzen der Einzelfertigungsschritte mit der Folge einer verringerten Qualität und unbefriedigenden Ausbeute bei gleichzeitig erhöhten Produktionskosten. Hieraus resultiert die Notwendigkeit einer permanenten aufwendigen Überprüfung der Produkt- und Prozessqualität. Notfalls müssen die Prozessschritte teilweise händisch nachjustiert werden.

Aufgabe der Erfindung ist es, ein Verfahren und eine Vorrichtung der eingangs erwähnten Art zu schaffen, bei der Qualität und Ausbeute bei der Herstellung von Piezowandlern gesteigert werden.

Diese Aufgabe wird durch ein Verfahren mit den Merkmalen des unabhängigen Anspruchs 1 und eine Vorrichtung mit den Merkmalen des unabhängigen Anspruchs 14 gelöst.

Gemäß dem erfindungsgemäßen Verfahren erfolgt ein Laminieren einer plattenartigen, mit Anschlusselementen aus elektrisch leitfähigem Material versehenen Kontaktierungseinheit, die eine Referenzmarkierung in ihrem mittleren Bereich und wenigstens eine in definiertem Abstand zur Referenzmarkierung liegende erste Nebenmarkierung aufweist und mehreren an die Kontaktierungseinheit angrenzenden Piezoschichten aus piezoelektrischem Material mit einer Tragkörper-Ausgangsstruktur zu einem Piezo-Laminat, wobei mittels einer Markierungserfassung eine Positionsorientierung an der Referenzmarkierung erfolgt.

Ferner findet ein Beschichten des Piezo-Laminats zu einem Piezo-Nutzen in mehreren Beschichtungsschritten mit unterschiedlichen Funktionsschichten statt, von denen wenigstens eine eine auf den Piezoschichten aufzubringende Elektrodenschicht aus elektrisch leitfähigem Material ist, wobei bei jedem Beschichtungsschritt eine Orientierung an der Referenzmarkierung erfolgt und wenigstens eine weitere Nebenmarkierung benachbart zu wenigstens einer ersten Nebenmarkierung angebracht wird, und wobei mittels der Markierungserfassung die relative Lage der benachbarten Nebenmarkierungen ermittelt und als Ist-Lage mit einer hinterlegten Soll-Lage verglichen wird, wobei bei Nicht-Überschreitung einer Soll-Abweichung zwischen Ist- und Soll-Lage der nächste oder letzte Beschichtungsschritt eingeleitet wird oder bei Überschreitung der Soll-Lage eine Nachjustierung bezüglich der Positionierung der Funktionsschichten im nächsten oder letzten Beschichtungsschritt und zusätzlich für das nachfolgend herzustellende Piezo-Bauteil stattfindet.

Schließlich findet eine Vereinzelung des Piezo-Nutzens zu Piezowandlern statt, wobei eine Orientierung zumindest an der Referenzmarkierung erfolgt.

Es ist also möglich, bereits beim Laminieren eine exakte Positionierung der einzelnen Bauelemente durch Orientierung an der Referenzmarkierung vorzunehmen. Beispielsweise kann die Kontaktierungseinheit lagegenau auf der Tragkörper-Ausgangsstruktur positioniert werden. Es ist aber auch möglich, das beim Laminieren entstandene Piezo-Laminat exakt zu positionieren, so dass die nachfolgenden Beschichtungsschritte mit einer hohen Präzision durchgeführt werden können. Beim Beschichten ist es durch den Ist/Soll-Wert-Vergleich möglich, bereits während des Prozesses Fehler zu erkennen und diese auch gleich während des Prozesses zu beheben. Es findet also eine in-situ Qualitätskontrolle statt. Wird eine nichttolerable Lageabweichung festgestellt, so ist es immer noch möglich, dieses Teil durch Lagejustierung für den nachfolgenden Beschichtungsschritt zu "retten". Diese Informationen stehen auch für das nachfolgende Piezo-Bauteil zur Verfügung, so das hier durch entsprechende Lagejustierung ein Überschreiten der Soll-Abweichung von vorneherein verhindert wird.

Durch die mittels des erfindungsgemäßen Verfahrens durchgeführte in-situ Qualitätskontrolle ist es möglich, bereits während des Verfahrens Fehler zu erkennen und dann gegenzusteuern, so dass insgesamt die Qualität und die Ausbeute an Piezowandlern erhöht wird. Gleichzeitig werden die Produktionskosten vermindert.

In besonders bevorzugter Weise ist eine optische Markierungserfassung vorgesehen. Bei den Markierungen kann es sich für die optische Markierungserfassung geeignete geometrische Markierungen handeln. Beispielsweise besitzen die geometrischen Markierungen optisch abgrenzbare, insbesondere scharfe Konturen. Als geometrische Markierungen kommen beispielsweise Kreuze, Rauten, ineinanderübergehende Kreise, Halbkreise, aus parallelen Linien aufgebaute Raster, Gitternetze usw. in Frage.

Ein weiterer Vorteil der Erfindung ist, dass beruhend auf dem zentralistischen Aufbau der Gesamtkomponenten basierend auf den Markierungen der Kontaktierungseinheit gewährleistet ist, dass die Toleranzen des Gesamtbauteils minimal sind.

Bei einer Weiterbildung der Erfindung ist wenigstens eine Referenz-Hilfsmarkierung im definierten Abstand zur Referenzmarkierung im Randbereich der Kontaktierungseinheit angebracht, wobei eine Positionsorientierung an der Referenzmarkierung und an der wenigstens einen Referenz-Hilfsmarkierung erfolgt. Es können also mindestens zwei Referenzpunkte vorgesehen sein, anhand derer eine Orientierung erfolgt, so dass zum Beispiel auch eine stärker im Randbereich auftretende Lageabweichung mit berücksichtigt wird.

In besonders bevorzugter Weise handelt es sich bei der wenigstens einen ersten Nebenmarkierung um eine zu vervollständigende Nebenmarkierung, die durch wenigstens eine in den Beschichtungsschritten aufgebrachte weitere Nebenmarkierung derart vervollständigt wird, dass ein sich ergänzendes Markierungsbild entsteht, das hinsichtlich der Lage der weiteren Nebenmarkierung mit einem hinterlegten idealen Markierungsbild verglichen wird. Dadurch kann also in einfacher Weise mittels optischer Erfassung des neu entstandenen Markierungsbilds eine Lageabweichung von der Soll-Lage ermittelt und mit der zulässigen Soll-Abweichung verglichen werden.

Bei der zu vervollständigenden ersten Nebenmarkierung kann es sich um ein Fadenkreuz handeln, dessen Quadranten schrittweise durch die Beschichtungsschritte mit weiteren Nebenmarkierungen, beispielsweise Quadrate oder Dreiecke, versehen werden. Alternativ oder zusätzlich kann wenigstens ein Kreisbogen vorgesehen sein, der schrittweise durch die Beschichtungsschritte mit weiteren Kreisbögen zu einem Kreis vervollständigt wird. Es ist auch möglich ein Raster, mit mehreren parallelen Hauptlinien vorzusehen, die schrittweise durch die Beschichtungsschritte mit zwischen benachbarten Hauptlinien liegenden Zwischenlinien versehen werden, deren Lage, insbesondere Abstand, in Bezug auf die Hauptlinien ermittelt wird.

In besonders bevorzugter Weise findet eine vorzugsweise kontinuierliche Datenübergabe insbesondere hinsichtlich Ist-Lage und Lageabweichung zwischen verschiedenen Prozessstationen statt. Dies kann zwischen zwei verschiedenen Prozessschritten, beispielsweise zwischen dem Laminieren und dem Beschichten, erfolgen oder innerhalb eines Prozessschritts zwischen zwei Teilschritten. Der in mehreren Beschichtungsschritten stattfindende Beschichtungsvorgang kann in einer Beschichtungseinrichtung mit mehreren Beschichtungseinheiten durchgeführt werden. Jede Beschichtungseinheit kann also einen Beschichtungsschritt durchführen. Nach jedem Beschichtungsschritt kann ein Ist-Soll-Lage-Vergleich durchgeführt werden, wobei die mit der zugeordneten Beschichtungseinheit ermittelten Daten an die nachgeordnete Beschichtungseinheit übermittelt werden. Es ist also nicht notwenig, dass jede Beschichtungseinheit eine separate Datenerfassung durchführt, sondern die Datenerfassung kann zentral, beispielsweise mittels einer Markierungserfassungseinrichtung, durchgeführt werden, wobei Daten von Beschichtungseinheit zu Beschichtungseinheit kontinuierlich weitergeleitet werden.

Es ist möglich, zusätzlich zur optischen Markierungserfassung eine Qualitätskontrolle, beispielsweise hinsichtlich Lage, Schichtdicke, elektrischer Leitfähigkeit der Schichten usw., mit nichtoptischen, insbesondere kapazitiven und/oder magnetischen Verfahren durchzuführen. Vorzugsweise erfolgt die nichtoptische Qualitätskontrolle am Ende eines jeweiligen Verfahrensschritts, insbesondere nach dem Vereinzeln am fertigen Piezowandler.

Beim Vereinzeln des Piezo-Nutzens kann eine Orientierung an der Referenzmarkierung und an der dem zu vereinzelnden Piezowandler zugeordneten Nebenmarkierung erfolgen. Das Vereinzeln kann durch Sägen, beispielsweise mit Hilfe eine Trennscheibe, durchgeführt werden. Es sind jedoch auch andere Vereinzelungsverfahren anwendbar, beispielsweise Laserschneiden usw..

Es ist möglich, dass zwischen zwei Verfahrens- bzw. Prozessschritten eine mechanische Entnahme des Piezo-Laminats bzw. Piezo-Nutzens aus einer Ausgangslage erfolgt, mit anschließender Bearbeitung des Piezo-Laminats bzw. Piezo-Nutzens in einer von der Ausgangslage entfernten oder bezüglich der Ausgangslage anders orientierten Bearbeitungslage und anschließendem Zurücktransportieren in die Ausgangslage, wobei eine Positionsorientierung an der Referenzmarkierung erfolgt. Dadurch ist es möglich, das Piezo-Laminat bzw. den Piezo-Nutzen exakt in die Ausgangsposition zurückzusetzen.

Die Erfindung umfasst ferner eine Vorrichtung zum Herstellen von Piezowandlern, mit:
- einer Laminiereinrichtung zum Laminieren einer plattenartigen, mit Anschlusselementen aus elektrisch leitfähigem Material versehenen Kontaktierungseinheit, und mehreren an die Kontaktierungseinheit angrenzenden Piezoschichten aus piezoelektrischem Material mit einer Tragkörper-Ausgangsstruktur zu einem Piezo-Laminat,
- einer Beschichtungseinrichtung mit wenigstens einer Beschichtungseinheit zum Beschichten des Piezo-Laminats zu einem Piezo-Nutzen in mehreren Beschichtungsschritten mit unterschiedlichen Funktionsschichten, von denen wenigstens eine eine auf den Piezoschichten aufzubringende Elektrodenschicht aus leitfähigem Material ist, einer Vereinzelungseinrichtung zum Vereinzeln des Piezo-Nutzens zu Piezowandlern, und
- einer Markierungserfassungseinrichtung mit einer Erfassungseinheit zum Erfassen der Position des Piezo-Laminats bzw. Piezo-Nutzens anhand einer Orientierung an einer an der Kontaktierungseinheit angeordneten Referenzmarkierung und zum Erfassen der relativen Lage von an der Kontaktierungseinheit angeordneten, benachbarten Nebenmarkierungen als Ist-Lage, und mit einer Auswerteeinheit zum Vergleich einer darin gespeicherten Soll-Lage mit der Ist-Lage, wobei bei Unterschreiten einer Soll-Abweichung zwischen Ist- und Soll-Lage der nächste oder letzte Beschichtungsschritt einleitbar oder bei Überschreiten der Soll-Abweichung eine Nachjustierung bezüglich der Positionierung der Funktionsschichten im nächsten oder letzten Beschichtungsschritt und zusätzlich für das nachfolgend herzustellende Piezo-Bauteil stattfindet.

Ein Beispiel für den Stand der Technik findet sich in Patentschrift US 2006/164466.

Bevorzugte Ausführungsbeispiele der Erfindung sind in der Zeichnung dargestellt und werden im Folgenden näher erläutert. In der Zeichnung zeigen:

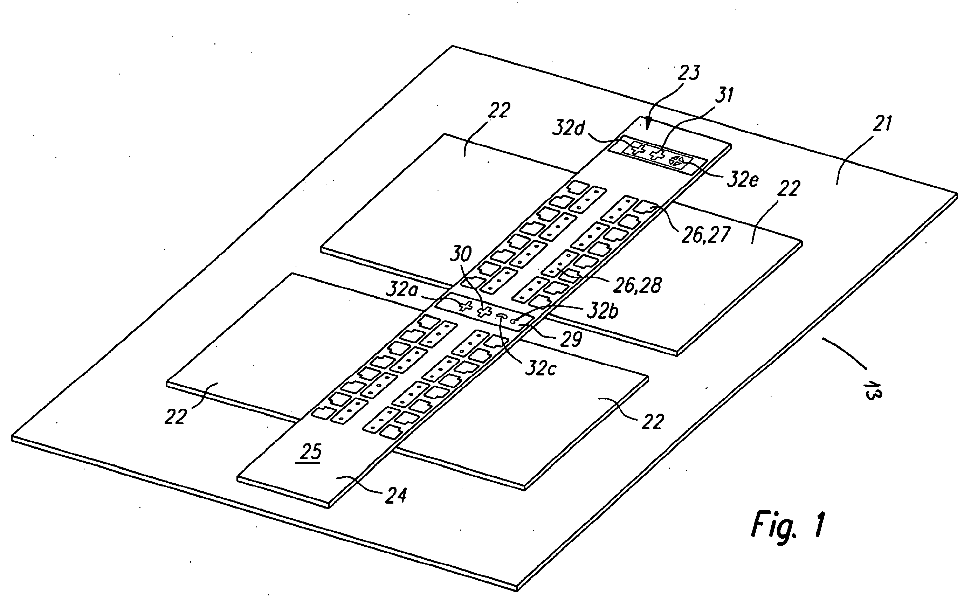

- Figur 1: eine perspektivische und schematische Ansicht auf ein nach dem Laminieren entstandenes Piezo-Laminat,
- Figur 2: eine vergrößerte Darstellung des mittleren Bereichs der Kontaktierungseinheit mit Referenzmarkierung und drei zu vervollständigenden ersten Nebenmarkierungen,
- Figur 3: eine vergrößerte Darstellung des Randbereichs der Kontaktierungseinheit mit Referenz-Hilfsmarkierung und zwei zu vervollständigenden ersten Nebenmarkierungen,
- Figur 4: das Piezo-Laminat nach dem ersten Beschichtungs-schritt,
- Figur 5: eine vergrößerte Darstellung des mittleren Bereichs der Kontaktierungseinheit, wobei die ersten Nebenmarkierungen jeweils durch eine einzelne weitere Nebenmarkierung vollständig sind,
- Figur 6: eine vergrößerte Darstellung des Randbereichs der Kontaktierungseinheit, wobei die ersten Nebenmarkierungen jeweils durch eine einzelne weitere Nebenmarkierung vervollständigt sind,
- Figur 7: das Piezo-Laminat von Figur 4 nach dem zweiten Beschichtungsschritt,
- Figur 8: der mittlere Bereich der Kontaktierungseinheit wobei eine der ersten Nebenmarkierungen bereits mit zwei weiteren Nebenmarkierungen versehen ist,
- Figur 9: eine vergrößerte Darstellung des Randbereichs der Kontaktierungseinheit, wobei die ersten Nebenmarkierungen jeweils zwei weitere Nebenmarkierungen aufweisen
- Figur 10: das Piezo-Laminat von Figur 7 nach dem dritten und letzten Beschichtungsschritt, wobei ein Piezo-Nutzen entstanden ist,
- Figur 11: ein vergrößerter Ausschnitt auf den mittleren Bereich der Kontaktierungseinheit, wobei eine der ersten Nebenmarkierungen drei weitere Nebenmarkierungen besitzt,
- Figur 12: ein vergrößerter Ausschnitt auf den Randbereich der Kontaktierungseinheit, wobei die ersten Nebenmarkierungen jeweils drei weitere Nebenmarkierungen aufweisen,
- Figur 13: eine perspektivische und vergrößerte Teilansicht der Kontaktierungseinheit, beim Vereinzeln des Piezo-Nutzens und
- Figur 14: eine schematische Darstellung der erfindungsgemäßen Vorrichtung zum Herstellen eines Piezowandlers.

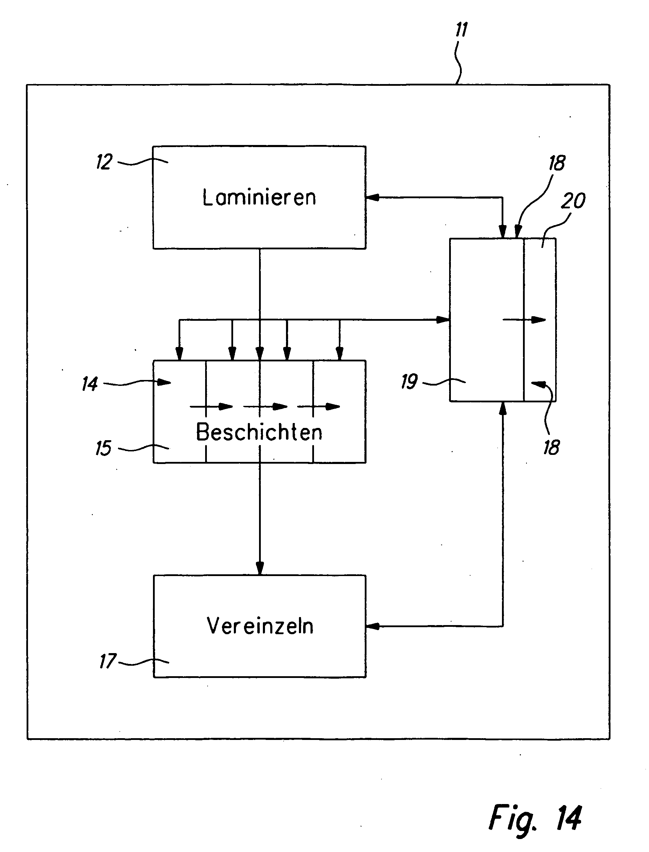

Figur 14 zeigt schematisch eine Vorrichtung 11 zur Herstellung von Piezowandlern. Obgleich sich die weitere Beschreibung der Erfindung an einem Piezo-Biegewandler orientiert, soll damit keine Einschränkung auf eine solche Produktgattung verbunden sein.

Der Piezo-Biegewandler kann Bestandteil eines zur Steuerung einer Fluidströmung dienenden Piezoventils sein.

Die Vorrichtung 11 umfasst eine Laminiereinrichtung 12, in der das nachfolgend näher beschriebene Laminieren unter bestimmtem Druck und bestimmter Temperatur stattfindet, wobei eine Piezo-Laminat 13 entsteht. Ferner umfasst die Vorrichtung 11 eine Beschichtungseinrichtung 14, die ihrerseits wenigstens eine Beschichtungseinheit 15 zum Beschichten des Laminats 13 in mehreren Beschichtungsschritten mit unterschiedlichen Funktionsschichten aufweist. Nach dem Beschichtungsvorgang entsteht aus dem Piezo-Laminat 13 ein Piezo-Nutzen 16. Zur Vorrichtung 11 gehört ferner noch eine Vereinzelungseinrichtung 17 zum Vereinzeln des Piezo-Nutzens 16 zu Piezo-Biegewandlern. Schließlich gehört zur Vorrichtung 11 noch eine Markierungserfassungseinrichtung 18, die der Laminiereinrichtung 12, der Beschichtungseinrichtung 14 und der Vereinzelungseinrichtung 17 zugeordnet ist und die eine Erfassungseinheit 19 zum Erfassen der Position des Piezo-Laminats 13 bzw. Piezo-Nutzens 16 bzw. zur Erfassung der genauen Lage der einzelnen Funktionsschichten aufweist, sowie eine Auswerteeinheit 20 zur Datenauswertung und zur Ansteuerung der einzelnen Einrichtungen zum Zwecke des Nachjustierens enthält.

Beim Laminieren wird eine Tragkörper-Ausgangsstruktur 21, die auch als Prepreg bezeichnet werden kann, bereitgestellt. Bei Prepreg handelt es sich um ein Halbzeug in Gestalt eines bevorzugt plattenartigen, noch nicht ausgehärteten, biegeschlaffen Rohlings mit eingebetteten Verstärkungsfasern. Diese Verstärkungsfasern liegen zweckmäßigerweise in einer oder mehreren unidirektionalen Schichten vor, die sich in Längs-oder Querrichtung des Prepregs erstrecken. Zweckmäßig ist eine Ausrichtung in Längsrichtung der nachfolgend noch beschriebenen Piezo-Schicht 22. Allerdings können die Verstärkungsfasern auch als Gewebe oder Gelege vorliegen. Das Prepreg lässt sich im noch nicht ausgehärtetem Zustand leicht verformen und in die gewünschte Gestalt bringen. Aufgrund seiner klebrigen Eigenschaften kann es zudem sehr präzise mit Komponenten bestückt werden.

Eine dieser Komponenten ist eine leiterplattenartig ausgebildete Kontaktierungseinheit 23, die eine aus elektrisch nicht leitendem Material bestehende Tragplatte 24 aufweist. Als Tragplatten-Material kommt glasfaserverstärktes Epoxydharz oder Kunstharz in Frage.

An der Oberseite 25 der Tragplatte 24, die später dem Tragkörper 21 abgewandt ist, sind mehrere Anschlusselemente 26 aus elektrisch leitendem Material, beispielsweise Kupfer angeordnet. Die Anschlusselemente 26, die auch als Anschlusspads bezeichnet werden, können beispielsweise fotolithografisch aufgebracht sein. Die Anschlusselemente 26 sind paarweise angeordnet, wobei ein erstes Anschlusspads 27 zur Kontaktierung der nachfolgend näher beschriebenen oberen Elektrode 35 und ein zweites Anschlusspad 28 zur Kontaktierung der unteren Elektrode dient.

Im mittleren Bereich 29 der Kontaktierungseinheit 23 befindet sich eine Referenzmarkierung 30, beispielhaft dargestellt in Form eines Kreuzes. Vorzugsweise bildet die Referenzmarkierung 30 genau den Mittelpunkt der Kontaktierungseinheit 23. Optional kann im Randbereich der Kontaktierungseinheit 23 eine Referenz-Hilfsmarkierung 31 vorgesehen sein, beispielsweise ebenfalls in Form eines Kreuzes. Die Referenzmarkierung 30 und gegebenenfalls die Referenz-Hilfsmarkierung 31 sind mittels der optischen Markierungserfassungseinrichtung 18 optisch erkennbar. Bereits bei der Bestückung der Tragkörper-Ausgangsstruktur 21 mit der Kontaktierungseinheit 23 kann eine Orientierung an der Referenzmarkierung 30 bzw. gegebenenfalls zusätzlich an der Referenz-Hilfsmarkierung 31 erfolgen, so dass die Kontaktierungseinheit 23 lagegenau auf der Tragkörper-Ausgangsstruktur 21 positioniert wird.

Im mittleren Bereich 29 und im Randbereich der Kontaktierungseinheit befinden sich erste Nebenmarkierungen 32a, 32b, 32c, 32d, 32e, vorzugsweise benachbart zur Referenzmarkierung 30 und gegebenenfalls benachbart zur Referenz-Hilfsmarkierung 31. Bei den ersten Nebenmarkierungen handelt es sich um zu vervollständigende Nebenmarkierungen 32a bis 32e, die in den nachfolgenden Prozessschritten schrittweise ergänzt und vervollständigt werden. Als Nebenmarkierungen eignen sich beispielsweise Fadenkreuze, Halbkreise oder Ähnliches. Im Folgenden wird die Erfindung beispielhaft anhand eines benachbart zur Referenzmarkierung 30 liegenden Fadenkreuzes 32a und zweier benachbart zur Referenzmarkierung 30 liegenden Halbkreisen 32b und 32c sowie anhand eines benachbart zur Referenzhilfs-Markierung 31 liegenden Fadenkreuzes 32d und eines aus Dreiecken gebildeten Quadrates 32e beschrieben. Es ist selbstverständlich auch möglich, andere geometrische Markierungen zu verwenden. Die an der Kontaktierungseinheit 23 ausgebildeten Markierungen können ebenfalls fotolithografisch aufgebracht werden.

Die Tragkörper-Ausgangsstruktur 21 wird ferner noch mit Piezo-Schichten 22 bestückt, von denen beispielhaft vier an der Zahl dargestellt sind. Die Piezo-Schichten 22 grenzen direkt an den Längsseiten der Kontaktierungseinheit an. Die Piezo-Schichten 22, die auch als piezoelektrische Körper bezeichnet werden können, bestehen aus einem piezoelektrisch aktivierbaren Material, insbesondere einer Blei-Zirkonat-Titan-Oxydkeramik (PZT) oder einer anderen Piezokeramik. Es ist ein monolithischer oder Multilayer-Aufbau der Piezo-Schichten denkbar.

Auch bei der Positionierung der Piezo-Schichten 22 auf der Tragkörper-Ausgangsstruktur 21 erfolgt eine Orientierung zumindest an der Referenzmarkierung 30, so dass diese lagegenau positioniert sind.

Beim Laminieren werden die Piezo-Schichten 22 unter Wärme-und Druckeinwirkung mit dem Tragkörper-Prepreg verpresst. Hierbei wird das Basismaterial des Tragkörper-Prepregs, beispielsweise Epoxidharz soweit verdrängt, dass die Unterseite der Piezo-Schichten 22 großflächig mit den elektrisch leitfähigen Verstärkungsfasern kontaktiert sind. Dieser Bereich der Verstärkungsfasern kann nunmehr eine untere Elektrode für die Piezo-Schichten 22 bilden. Auch zwischen der Kontaktierungseinheit 23 und der Tragkörper-Ausgangsstruktur 21 bildet sich beim Aushärten der Tragkörper-Ausgangsstruktur 21 unter erhöhter Temperatur eine stoffschlüssige Verbindung, so dass eine festzusammenhaltende Baueinheit vorliegt. Der Tragkörper-Ausgangsstruktur 21 wird nach dem Laminieren zum Tragkörper 21. Insgesamt entsteht nach dem Laminierprozess ein Piezo-Laminat 13.

Nach dem Laminieren erfolgt wiederum eine Positionsorientierung an der Referenzmarkierung 30, so dass das Piezo-Laminat 13 für das anschließende Beschichten lagegenau in der Beschichtungseinrichtung 14, insbesondere in der ersten Beschichtungseinheit 15 positioniert ist.

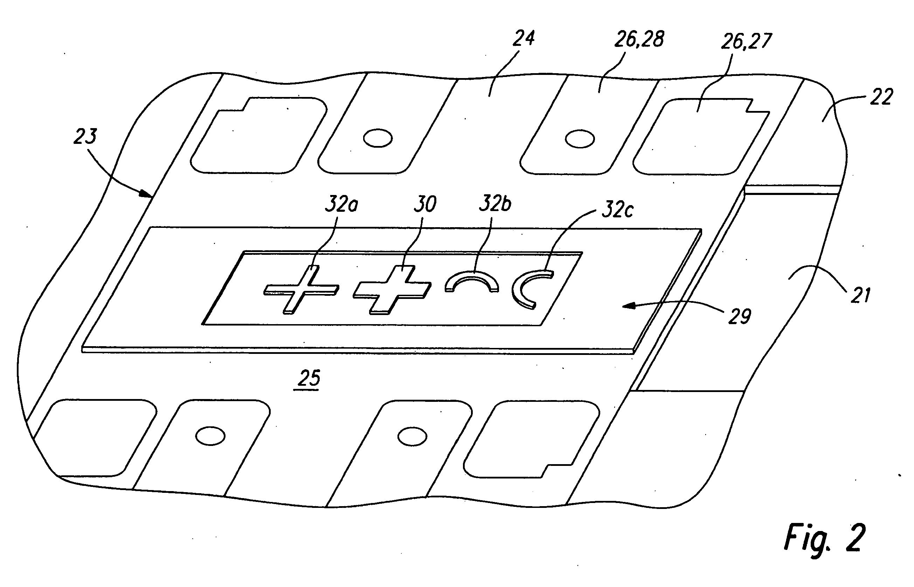

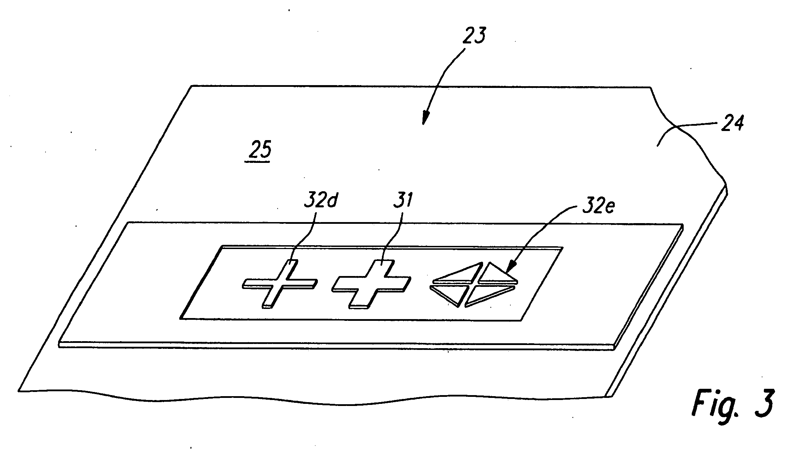

Die Figuren 2 und 3 zeigen den mittleren Bereich 29 und den Randbereich der Kontaktierungseinheit 23 nach dem Laminieren, wobei die ersten Nebenmarkierungen 32a bis 32e noch "blank", also noch nicht vervollständigt sind.

Das nachfolgende Beschichten wird beispielsweise mittels Siebdruck oder Sputtern durchgeführt. Zweckmäßigerweise wird jeder Beschichtungsschritt in einer eigens hierfür vorgesehenen Beschichtungseinheit 15 durchgeführt.

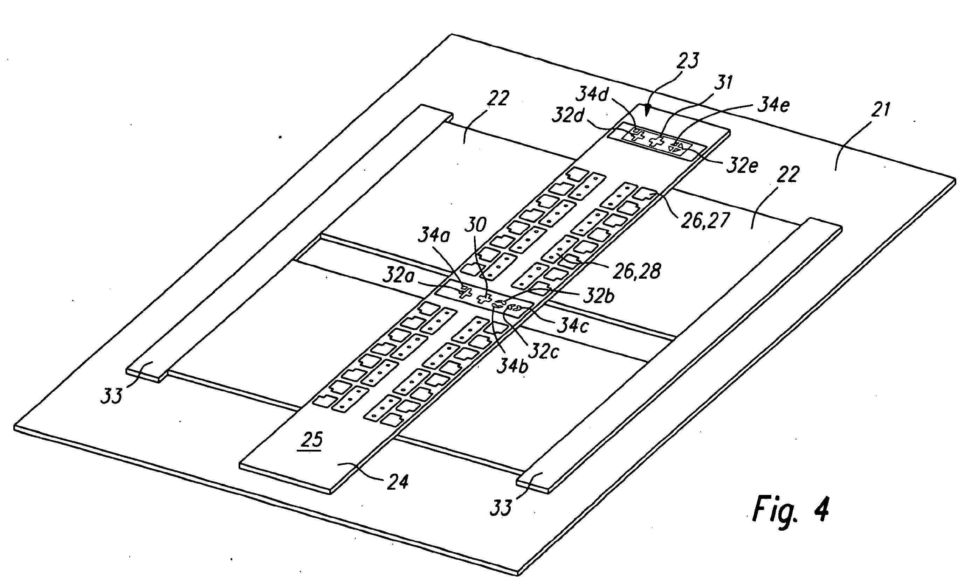

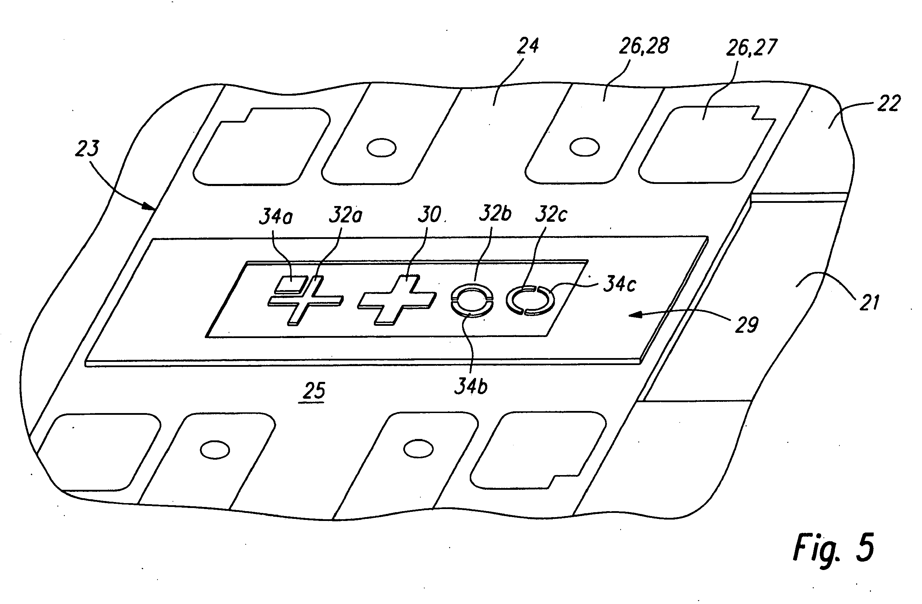

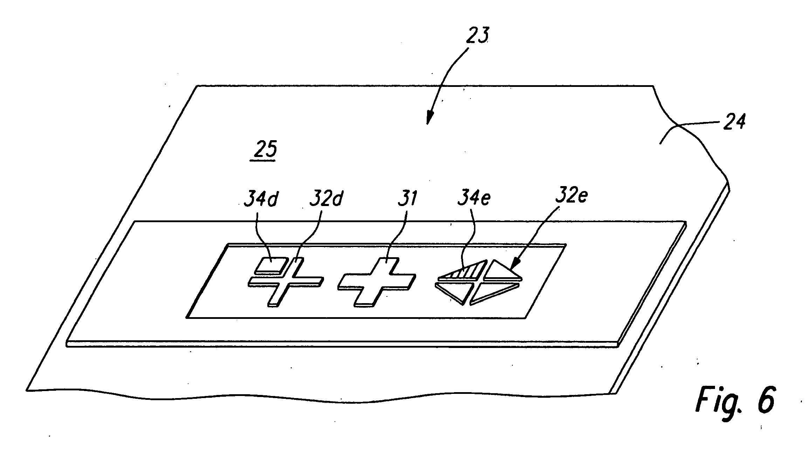

Die Figur 4 zeigt die Situation nach dem ersten Beschichtungsschritt in der ersten Beschichtungseinheit 15. Hier wurden an den der Kontaktierungseinheit 23 gegenüberliegenden Rändern der Piezo-Schichten 22 Dielektrika 33, also Schichten aus nicht elektrisch leitfähigem Material, aufgedruckt. Wie insbesondere in den Figuren 5 und 6 dargestellt, wurden gleichzeitig die ersten Nebenmarkierungen 32a bis 32e durch weitere Nebenmarkierungen 34a bis 34e vervollständigt. Beispielsweise wurde die als Fadenkreuz ausgebildete erste Nebenmarkierung 32a im Bereich der Referenzmarkierung 30 mit einer einzelnen weiteren Nebenmarkierung 34a in deren erstem Quadranten ergänzt, beispielsweise kann hierfür ein Quadrat vorgesehen sein. Die in Form von Halbkreisen ausgebildeten ersten Nebenmarkierungen 32b, 32c im Bereich der Referenzmarkierung 30 wurde beispielsweise mit einem ergänzenden Halbkreis zu einem Vollkreis ergänzt. Auch im Randbereich der Kontaktierungseinheit 23 kann die als Fadenkreuz ausgebildete erste Nebenmarkierung 32d mit einer einzelnen weiteren Nebenmarkierung 34d im ersten Quadranten ergänzt sein, hierfür eignet sich beispielsweise auch ein Quadrat. Es wäre jedoch auch ein Ergänzung in Form eines Dreiecks oder eines anderen geometrischen Symbols möglich. Schließlich ist die aus Dreiecken aufgebaute quadratische erste Nebenmarkierung 32e im Bereich ihres im ersten Quadranten sitzenden Dreiecks mit einer einzelnen weiteren Nebenmarkierung 34e in Form einer Bedruckung versehen.

Die Lage der benachbarten Nebenmarkierungen 32a bis 32e bzw. 34a bis 34e, das heißt die relative Lage zwischen einer der ersten Nebenmarkierungen 32a bis 32e und der ihr zugeordneten beim ersten Beschichtungsschritt angebrachten weiteren Nebenmarkierung 34a bis 34e wird nun als Ist-Lage mit einer hinterlegten Soll-Lage verglichen. Beispielsweise entsteht durch eine jeweilige beim Beschichten aufgebrachte weitere Nebenmarkierung 34a bis 34e ein charakteristisches Markierungsbild, das mit einem hinterlegten idealen Markierungsbild verglichen wird. Wird die zulässige Soll-Abweichung zwischen Ist- und Soll-Lage nicht überschritten, wird der nächste oder letzte Beschichtungsschritt eingeleitet. Beispielsweise wird optisch ermittelt, ob das im ersten Quadranten der fadenkreuzartigen ersten Nebenmarkierung 32a befindliche Quadrat richtig positioniert liegt. Gleichzeitig wird mittels der optischen Markierungserfassung ermittelt, ob die halbkreisartigen ersten Nebenmarkierungen 32b, 32c auch exakt zu Vollkreisen durch die halbkreisartigen weiteren Nebenmarkierungen 34b, 34c ergänzt sind. Im Randbereich der Kontaktierungseinheit 23 wird ebenso verfahren. Insbesondere wird bei der aus Dreiecken aufgebauten quadratischen ersten Nebenmarkierung 32a geprüft, ob die Bedruckung des im ersten Quadranten liegenden Dreiecks vollflächig erfolgt ist. Das Anbringen von zu vervollständigenden ersten Nebenmarkierungen 32d und 32e im Randbereich der Kontaktierungseinheit 23 macht Sinn, um die Lageabweichung auch im Randbereich festzustellen, die möglicherweise von der Lageabweichung im mittleren Bereich der Kontaktierungseinheit 23 abweicht. Beispielsweise ist es möglich, dass die Dielektrika 33 gerade im Randbereich mit großer Lageabweichung zwischen Ist- und Soll-Lage aufgedruckt wurden.

Die zulässige Soll-Abweichung bzw. die maximal zulässige Toleranz kann je nach Bereich der Kontaktierungseinheit unterschiedlich groß sein. Vorzugsweise liegt die zulässige Soll-Abweichung bei ≤ 300µm, insbesondere bei ≤ 20µm.

Wird die Soll-Abweichung überschritten, findet eine Nachjustierung für den nachfolgenden Beschichtungsschritt statt, so dass die folgenden Beschichtungen dann innerhalb des Toleranzfeldes liegen müssten und das gesamte Bauteil "gerettet" werden kann. Zusätzlich dazu findet auch eine Nachjustierung für das Herstellungsverfahren des nächsten Piezo-Bauteils statt.

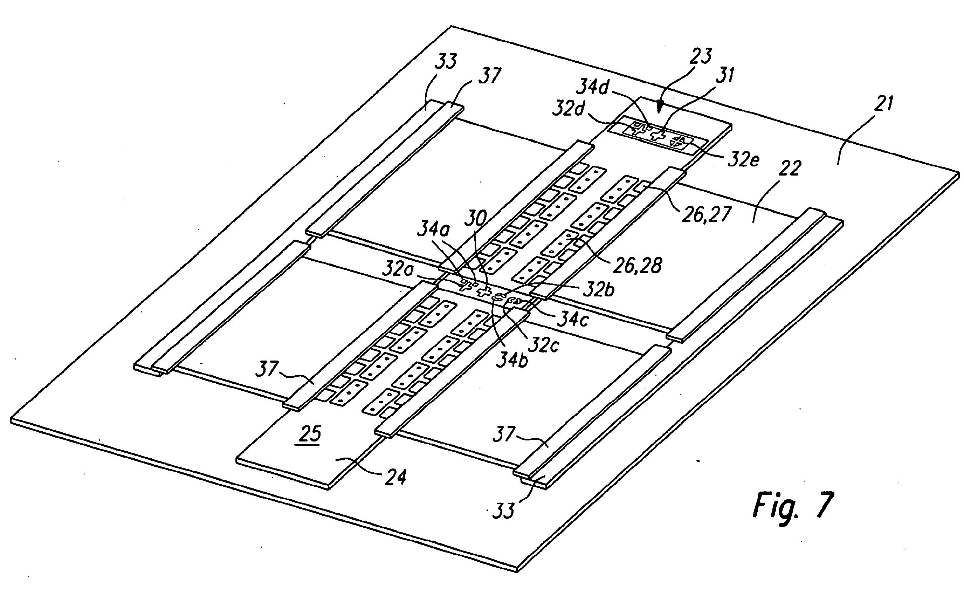

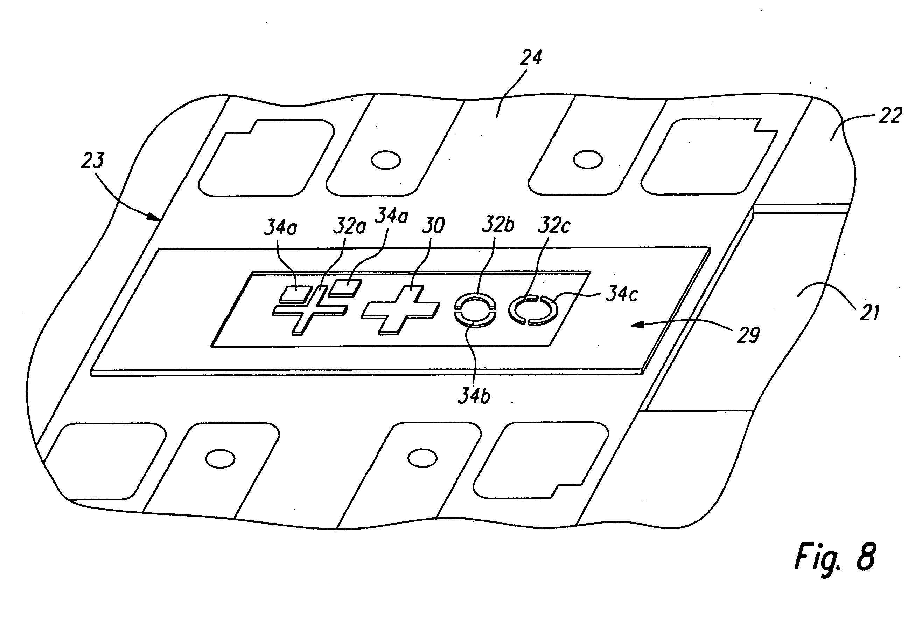

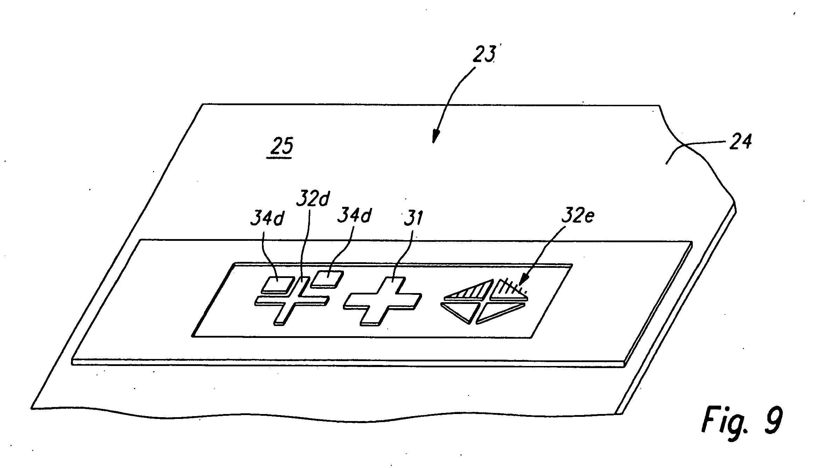

Wie in den Figuren 7 bis 9 dargestellt, werden als Nächstes weitere Dielektrika 37 aufgedruckt, die den Spalt zwischen der Längsseite der Piezo-Schichten 22 und der zugewandten Längsseite der Kontaktierungseinheit 23 überbrücken. Gleichzeitig werden die ersten Nebenmarkierungen 32a bis 32e durch weitere Nebenmarkierungen 34a bis 34e ergänzt bzw. vervollständigt. Beispielsweise weisen dann die als Fadenkreuze ausgebildeten ersten Nebenmarkierungen 32a, 32d auch im zweiten Quadranten liegende Quadrate oder Ähnliches auf. Auch die aus Dreiecken aufgebaute quadratische erste Nebenmarkierung 32e weist eine Bedruckung auf dem im zweiten Quadranten liegenden Dreieck auf. Beispielhaft ist hier gezeigt, dass die Quadrate bzw. Bedruckung nicht exakt liegen, das deutet darauf hin, das der Beschichtungsvorgang nicht exakt durchgeführt wurde. Es muss nun festgestellt werden, ob die Lageabweichung die zulässige Soll-Abweichung überschreitet, so dass eine Nachjustierung einzuleiten ist.

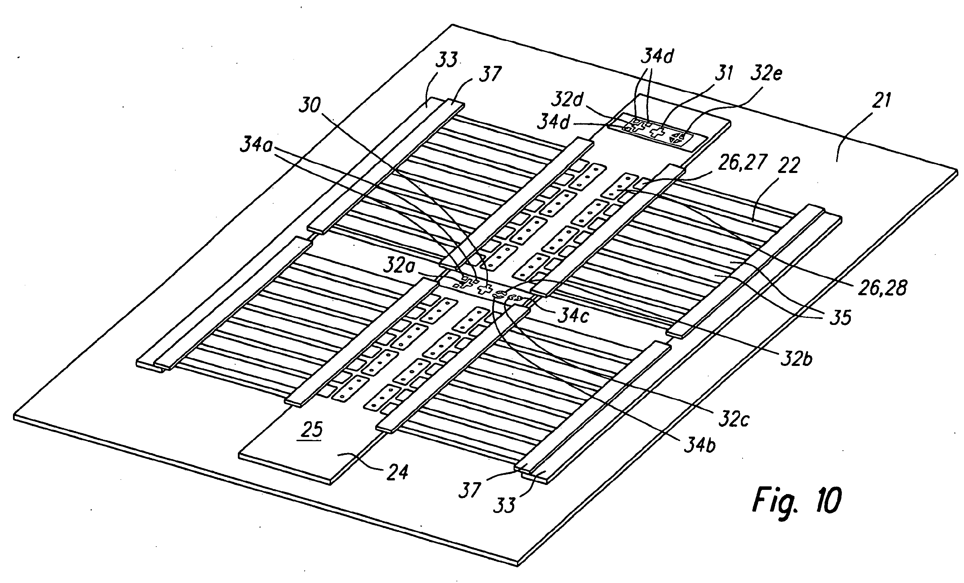

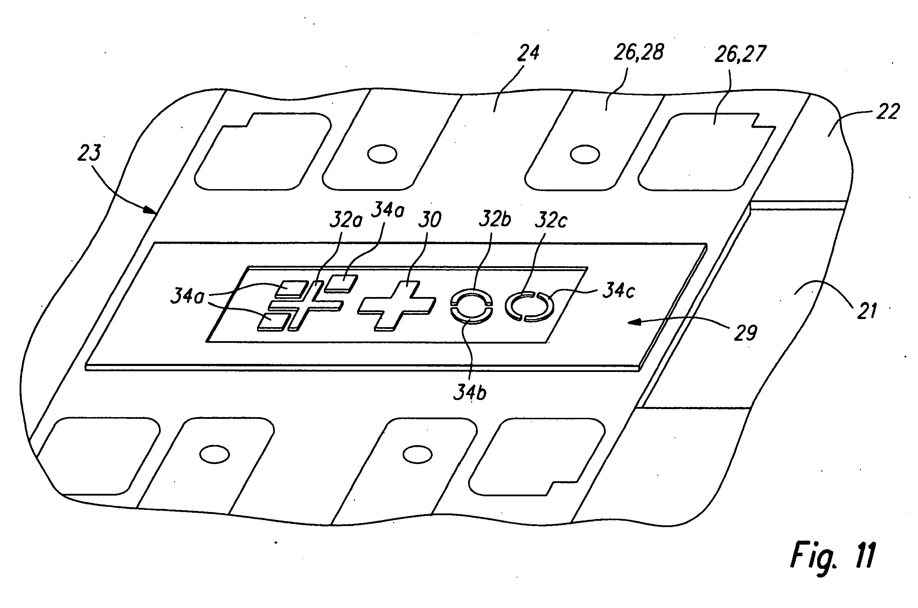

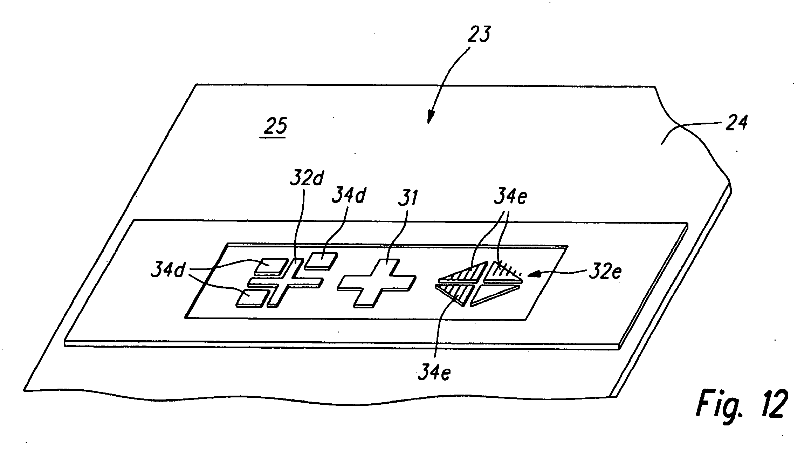

Wie in den Figuren 10 bis 12 dargestellt, werden beim nächsten Beschichtungsschritt auf die Piezo-Schichten dünne, elektrisch leitfähige Schichten aufgedruckt, die die oberen Elektroden 35 bilden. Beispielsweise eignet sich hierfür Kohlefasermaterial. Auch in diesem Beschichtungsschritt werden die ersten Nebenmarkierungen 32a bis 32e durch weitere Nebenmarkierungen 34a bis 34e ergänzt. Beispielsweise sind dann in der als Fadenkreuz ausgebildeten ersten Nebenmarkierung 32a in drei Quadranten Quadrate oder Ähnliches angeordnet. Auch hier wird wiederum aus der Lage des bei diesem Beschichtungsschritt aufgebrachten weiteren Nebenmarkierung in Bezug auf die zugeordnete erste Nebenmarkierung 32a auf die Qualität und Lage der aufgebrachten Beschichtungen geschlossen.

Insgesamt wird also nach jedem Beschichtungsschritt ein Ist-Soll-Lagevergleich der Nebenmarkierungen 32a bis 32e; 34a bis 34e durchgeführt, woraus auf die Qualität, sprich exakte Lage der Beschichtungen geschlossen werden kann. Gegebenenfalls werden Gegenmaßnahmen eingeleitet, beispielsweise eine Nachjustierung für den nachfolgenden Beschichtungsschritt mit gleichzeitiger Nachjustierung für das nachfolgend herzustellende Piezo-Bauteil. Dabei werden die ermittelten Daten von Beschichtungseinheit zu Beschichtungseinheit kontinuierlich übergeben. Insgesamt findet hier also eine in-situ Qualitätskontrolle des Beschichtungsvorgangs statt. Nach dem Beschichten entsteht aus dem Piezo-Laminat 13 ein Piezo-Nutzen 16, der im nachfolgenden Vereinzelungsschritt zu Piezo-Biegewandlern vereinzelt wird.

Bei jedem Beschichtungsschritt erfolgt eine Orientierung zumindest an der Referenzmarkierung 30, vorzugsweise an der Referenzmarkierung 30 und an der Referenz-Hilfsmarkierung 31 und an den ersten Nebenmarkierungen 32a bis 32e, so dass jeweilige Beschichtungseinheit 15 und Piezo-Laminat 13 lagegenau zueinander positioniert sind. Dadurch können bereits vor dem einzuleitenden Beschichtungsschritt Beschichtungsfehler infolge nicht exakter Positionierung vermieden werden.

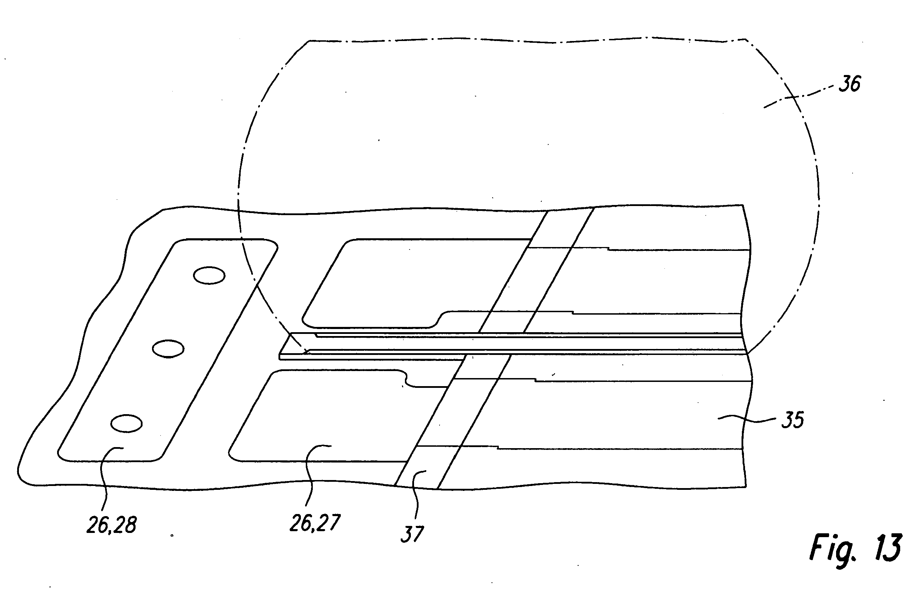

Wie in Figur 13 dargestellt, wird der Piezo-Nutzen 16 in der Vereinzelungseinrichtung 17 zu Piezo-Biegewandlern vereinzelt. Das Vereinzeln findet durch einen Sägeprozess mit einer Trennscheibe 36 statt, wobei hier wiederum auch eine Orientierung an der Referenzmarkierung 30 und an den Nebenmarkierungen 32a bis 32e bzw. 34a bis 34e erfolgt. So können exakte Schnittlinien gesetzt werden, so dass Piezo-Biegewandler mit nahezu denselben Abmessungen entstehen.

Gegebenenfalls kann an der Unterseite des Tragkörpers 21 noch eine piezoelektrisch nicht aktivierbare Anpassschicht vorgesehen sein, die zur Kompensation thermisch bedingter Materialverformungen dient. Sie gewährleistet in einem vorgebebenen Rahmen ein neutrales Verhalten des Piezo-Biegewandlers ungeachtet eventueller Temperaturschwankungen.

## Patentansprüche

1. Verfahren zur Herstellung von Piezowandlern, das Verfahren mit folgenden Schritten:
- Laminieren einer plattenartigen, mit Anschlusselementen (26) aus elektrisch leitfähigem Material versehenen Kontaktierungseinheit (23), die eine Referenzmarkierung (30) in ihrem mittleren Bereich (29) und wenigstens eine in definiertem Abstand zur Referenzmarkierung (30) liegende erste Nebenmarkierung (32a-32e) aufweist, und mehreren an die Kontaktierungseinheit (23) angrenzenden Piezo-Schichten (22) aus piezoelektrischem Material mit einer Tragkörper-Ausgangsstruktur (21) zu einem Piezo-Laminat (13), wobei mittels einer Markierungserfassung eine Positionsorientierung an der Referenzmarkierung (30) erfolgt,
- Beschichten des Piezo-Laminats (13) zu einem Piezo-Nutzen (16) in mehreren Beschichtungsschritten mit unterschiedlichen Funktionsschichten, von denen wenigstens eine, eine auf den Piezo-Schichten (22) aufzubringende Elektrodenschicht (35) aus elektrisch leitfähigem Material ist, wobei bei jedem Beschichtungsschritt eine Orientierung an der Referenzmarkierung (30) erfolgt und wenigstens eine weitere Nebenmarkierung (34a-34e) benachbart zu wenigstens einer ersten Nebenmarkierung (32a-32e) angebracht wird, und wobei mittels der Markierungserfassung die relative Lage der benachbarten Nebenmarkierungen (32a-32e, 34a-34e) ermittelt und als Ist-Lage mit einer hinterlegten Soll-Lage verglichen wird, wobei bei Nicht-Überschreitung einer Soll-Abweichung zwischen Ist- und Soll-Lage der nächste oder letzte Beschichtungsschritt eingeleitet wird oder bei Überschreitung der Soll-Lage eine Nachjustierung bezüglich der Positionierung der Funktionsschichten im nächsten oder letzten Beschichtungsschritt und zusätzlich für das nachfolgend herzustellende Piezo-Bauteil stattfindet,
- Vereinzeln des Piezo-Nutzens (17) zu Piezo-Wandlern, wobei eine Orientierung zumindest an der Referenzmarkierung (30) erfolgt.

2. Verfahren nach Anspruch 1 **gekennzeichnet durch** eine optische Markierungserfassung.

3. Verfahren nach Anspruch 1 oder 2, **dadurch gekennzeichnet, dass** es sich bei den Markierungen (30, 32a-32e, 34a-34e) für optische markierungserfassung um geeignete geometrische Markierungen handelt.

4. Verfahren nach einem der vorhergehenden Ansprüche, **dadurch gekennzeichnet, dass** die Referenzmarkierung (30) auf dem Mittelpunkt der Kontaktierungseinheit (23) angeordnet ist.

5. Verfahren nach einem der vorhergehenden Ansprüche, **dadurch gekennzeichnet, dass** wenigstens eine Referenz-Hilfsmarkierung (31) im definierten Abstand zur Referenzmarkierung (30) im Randbereich der Kontaktierungseinheit (23) angebracht ist und eine Positionsorientierung an der Referenzmarkierung (30) und an der wenigstens einen Referenz-Hilfsmarkierung (31) erfolgt.

6. Verfahren nach einem der vorhergehenden Ansprüche, **dadurch gekennzeichnet, dass** es sich bei der wenigstens einen Nebenmarkierung (32a-32b) um eine zu vervollständigende Nebenmarkierung (32a-32e) handelt, die durch wenigstens eine in den Beschichtungsschritten aufgebrachte weitere Nebenmarkierung (34a-34e) derart vervollständigt wird, dass ein sich ergänzendes Markierungsbild entsteht, das hinsichtlich der Lage der weiteren Nebenmarkierung (34a-34e) mit einem hinterlegten idealen Markierungsbild verglichen wird.

7. Verfahren nach Anspruch 6, **dadurch gekennzeichnet, dass** als zu vervollständigende erste Nebenmarkierung (32a-32e) ein Fadenkreuz (32a, 32e), dessen Quadranten schrittweise durch die Beschichtungsschritte mit weiteren Nebenmarkierungen (34a, 34d) versehen werden und/oder ein Kreisbogen (32b, 32c,), der schrittweise durch die Beschichtungsschritte mit weiteren Kreisbögen (34b, 34c) zu einem Kreis vervollständigt wird und/oder ein Raster mit mehreren parallelen Linien, die schrittweise durch die Beschichtungsschritte mit Zwischenlinien versehen werden, vorgesehen ist.

8. Verfahren nach einem der vorhergehenden Ansprüche, **dadurch gekennzeichnet, dass** eine vorzugsweise kontinuierliche Datenübergabe insbesondere hinsichtlich Lage und Soll-Abweichung zwischen den einzelnen Verfahrensschritten, insbesondere zwischen den einzelnen Beschichtungsschritten, stattfindet.

9. Verfahren nach einem der vorhergehenden Ansprüche, **dadurch gekennzeichnet, dass** die zulässige Soll-Abweichung bei ≤ 300 µm, insbesondere brei ≤ 20 µm liegt.

10. Verfahren nach einem der vorhergehenden Ansprüche, **dadurch gekennzeichnet, dass** zusätzlich zur optischen Markierungserfassung eine Qualitätskontrolle mit nichtoptischen, insbesondere kapazitiven und/oder magnetischen Verfahren erfolgt.

11. Verfahren nach einem der vorhergehenden Ansprüche, **dadurch gekennzeichnet, dass** zwischen zwei Verfahrensschritten eine mechanische Entnahme des Piezo-Laminats (13) bzw. Piezo-Nutzen (16) aus einer Ausgangslage erfolgt, mit anschließender Bearbeitung des Piezo-Laminats (13) bzw. Piezo-Nutzens (16) in einer von der Ausgangslage entfernten oder bezüglich der Ausgangslage anders orientierten Bearbeitungslage und anschließendes Zurücktransportieren in die Ausgangslage, wobei eine Positionsorientierung an der Referenzmarkierung (30) erfolgt.

12. Verfahren nach einem der vorhergehenden Ansprüche, **dadurch gekennzeichnet, dass** das Vereinzeln mittels eines sägevorgangs durchgeführt wird.

13. Verfahren nach einem der vorhergehenden Ansprüche, **dadurch gekennzeichnet, dass** es sich bei dem Piezo-Wandler um einen Piezo-Biegewandler handelt.

14. Vorrichtung zum Herstellen von Piezowandlern , mit:
- einer Laminiereinrichtung (12) zum Laminieren einer plattenartigen, mit Anschlusselementen (26) aus elektrisch leitfähigem Material versehenen Kontaktierungseinheit (23), und mehreren an die Kontaktierungseinheit angrenzenden Piezo-Schichten (22) aus piezoelektrischem Material mit einer Tragkörper-Ausgangsstruktur (21) zu einem Piezo-Laminat (13),
- einer Beschichtungseinrichtung (14) mit wenigstens einer Beschichtungseinheit (15) zum Beschichten des Piezo-Laminats (13) in mehreren Beschichtungsschritten mit unterschiedlichen Funktionsschichten, von denen wenigstens eine eine auf den Piezoschichten (22) aufzubringende Elektrodenschicht (35) aus elektrisch leitfähigem Material ist,
- einer vereinzelungseinrichtung (17) zum Vereinzeln der Piezo-Nutzens (16) zu Piezo-Wandlern und
- einer Markierungserfassungseinrichtung (18) mit einer Erfassungseinheit (19) zum Erfassen der Position des Piezo-Laminats (13) bzw. Piezo-Nutzens (16) anhand einer Orientierung an einer an der Kontaktierungseinheit (23) angeordneten Referenzmarkierung (30) und zum Erfassen der relativen Lage von an der Kontaktierungseinheit (22) angeordneten, benachbarten Nebenmarkierungen (32a-32e, 34a-34e) als Ist-Lage, und mit einer Auswerteeinheit (20) zum Vergleich einer darin gespeicherten Soll-Lage mit der Ist-Lage.

## Claims

1. Method for the production of piezoelectric transducers, the method comprising the following steps:
- laminating a plate-like contacting unit (23) provided with connecting elements (26) of an electrically conductive material and having a reference marking (30) in its central region (29) and at least one first secondary marking (32a-32e) at a defined distance from the reference marking (30) to a plurality of piezoelectric layers (22) adjoining the contacting unit (23) and made of a piezoelectric material with a support body starting structure (21) to produce a piezoelectric laminate (13), wherein a position orientation is effected against the reference marking (30) by means of a marking detection;
- coating the piezoelectric laminate (13) to produce a piezo panel (16) in several coating steps with different functional layers of which at least one is an electrode layer (35) of an electrically conductive material, which is to be applied to the piezoelectric layers (22), wherein an orientation against the reference marking (30) is effected in each coating step and at least one further secondary marking (34a-34e) is applied adjacent to the at least one first secondary marking (32a-32e), and wherein by means of marking detection the relative position of the adjacent secondary markings (32a-32e, 34a-34e) is determined and compared as actual position to a stored set position, wherein, if a set variation between actual and set position is not exceeded, the next or last coating step is initiated, or, if the set position is exceeded, the positioning of the functional layers is readjusted in the next or last coating step and in addition for the next piezoelectric component to be produced;
- segregating the piezo panel (17) into piezoelectric transducers accompanied by orientation against at least the reference marking (30).

2. Method according to claim 1, **characterised by** optical marking detection.

3. Method according to claim 1 or 2, **characterised in that** the markings (30, 32a-32e, 34a-34e) are geometrical markings suitable for optical marking detection.

4. Method according to any of the preceding claims, **characterised in that** the reference marking (30) is located in the centre of the contacting unit (23).

5. Method according to any of the preceding claims, **characterised in that** at least one auxiliary reference marking (31) is applied at a defined distance from the reference marking (30) in the edge region of the contacting unit (23) and a position orientation is effected against the reference marking (30) and the at least one auxiliary reference marking (31).

6. Method according to any of the preceding claims, **characterised in that** the at least one secondary marking (32a-32e) is a secondary marking (32a-32e) to be completed, which is completed by at least one further secondary marking (34a-34e) applied in the coating steps such that a complementary marking pattern is generated which is compared to a stored ideal marking pattern with respect to the position of the further secondary marking (34a-34e).

7. Method according to claim 6, **characterised in that** the first secondary marking (32a-32e) to be completed is a set of cross hairs (32a, 32e) the quadrants of which are gradually provided with further secondary markings (34a, 34e) in the coating steps, and/or an arc (32b, 32c) which is gradually completed to form a circle by means of further arcs (34b, 34c) in the coating steps, and/or a grid with a plurality of parallel lines which are gradually provided with intermediate lines in the coating steps.

8. Method according to any of the preceding claims, **characterised in that** a preferably continuous data transfer is effected, in particular with respect to position and set variation between the individual process steps, in particular between the individual coating steps.

9. Method according to any of the preceding claims, **characterised in that** the permissible variation is ≤ 300 µm, in particular ≤ 20 µm.

10. Method according to any of the preceding claims, **characterised in that** the optical marking detection is supplemented by a quality control using non-optical, in particular capacitive and/or magnetic, methods.

11. Method according to any of the preceding claims, **characterised in that** between two process steps a mechanical removal of the piezoelectric laminate (13) or the piezo panel (16) from a starting position is effected, followed by a processing of the piezoelectric laminate (13) or the piezo panel (16) in a processing position remote from the starting position or oriented differently therefrom, followed by a return to the starting position, wherein a position orientation is effected against the reference marking (30).

12. Method according to any of the preceding claims, **characterised in that** the segregation is effected by means of a sawing process.

13. Method according to any of the preceding claims, **characterised in that** the piezoelectric transducer is a piezoelectric bending transducer.

14. Device for producing piezoelectric transducers, comprising:
- a laminating apparatus (12) for laminating a plate-like contacting unit (23) provided with connecting elements (26) of an electrically conductive material to a plurality of piezoelectric layers (22) adjoining the contacting unit and made of a piezoelectric material with a support body starting structure (21) to produce a piezoelectric laminate (13);
- a coating apparatus (14) with at least one coating unit (15) for coating the piezoelectric laminate (13) in several coating steps with different functional layers of which at least one is an electrode layer (35) of an electrically conductive material, which is to be applied to the piezoelectric layers (22);
- a segregating apparatus (17) for segregating the piezo panel (16) into piezoelectric transducers; and
- a marking detection device (18) with a detection unit (19) for detecting the position of the piezoelectric laminate (13) or the piezo panel (16) using an orientation against a reference marking (30) applied to the contacting unit (23) and for detecting the relative position of adjacent secondary markings (32a-32e, 34a-34e) on the contacting unit (23) as actual position, and with an evaluation unit (20) for comparing a set position stored therein to the actual position.

## Revendications

1. Procédé de fabrication de transducteurs piézoélectriques, le procédé comprenant les étapes suivantes consistant à :
- laminer une unité de mise en contact (23) se présentant sous la forme d'une plaque, équipée d'éléments de raccordement (26) en matériau conducteur électrique, laquelle présente un marquage de référence (30) au niveau de sa zone centrale (29) et au moins un premier marquage secondaire (32a - 32e) se trouvant à une distance définie du marquage de référence (30), et comportant plusieurs couches piézoélectriques (22) attenantes à l'unité de mise en contact (23) et composées d'un matériau piézoélectrique assemblées sur une structure de départ de corps support (21) pour former un laminé piézoélectrique (13), une détection du marquage permettant d'orienter la position par rapport au marquage de référence (30),
- revêtir le laminé piézoélectrique (13) pour former un flan piézoélectrique (16) avec différentes couches fonctionnelles en plusieurs étapes de revêtement, au moins l'une d'entre elles étant une couche d'électrodes (35) en matériau conducteur électrique devant être appliquée sur la couche piézoélectrique (22), une orientation étant effectuée, à chaque étape de revêtement, par rapport au marquage de référence (30) et au moins un autre marquage secondaire (34a - 34e) étant appliqué à côté d'au moins un premier marquage secondaire (32a - 32e) et la position relative des marquages secondaires voisins (32a - 32e, 34a - 34e) étant détectée au moyen d'une détection du marquage et comparée en tant que position réelle avec une position de consigne mise en mémoire, l'étape de revêtement suivante ou la dernière étape de revêtement étant réalisée en cas de non dépassement d'un écart seuil entre la position réelle et la position de consigne ou un réajustement étant effectué, en cas de dépassement de la position de consigne, par rapport au positionnement des couches fonctionnelles dans l'étape de revêtement suivante ou la dernière étape de revêtement et, pour le composant piézoélectrique devant être fabriqué par la suite,
- séparer le flan piézoélectrique (17) pour former le transducteur piézoélectrique, une orientation au moins par rapport au marquage de référence (30) étant effectuée.

2. Procédé selon la revendication 1, **caractérisé par** une détection optique du marquage.

3. Procédé selon la revendication 1 ou 2, **caractérisé en ce que** les marquages (30, 32a - 32e, 34a - 34e) pour la détection optique du marquage sont des marquages géométriques appropriés.

4. Procédé selon l'une des revendications précédentes, **caractérisé en ce que** le marquage de référence (30) est disposé au centre de l'unité de mise en contact (23).

5. Procédé selon l'une des revendications précédentes, **caractérisé en ce qu'**au moins un marquage auxiliaire de référence (31) est appliqué à une distance définie par rapport au marquage de référence (30) dans la zone de bord de l'unité de mise en contact (23) et une orientation de la position par rapport au marquage de référence (30) et au/aux marquage(s) auxiliaire(s) de référence (31) est effectuée.

6. Procédé selon l'une des revendications précédentes, **caractérisé en ce que** le/les marquage(s) secondaire(s) (32a - 32b) est/sont un marquage secondaire (32a - 32e) devant être complété, qui est complété par au moins un autre marquage secondaire (34a -34e) appliqué pendant l'étape de revêtement de telle sorte qu'il en résulte une image de marquage complémentaire qui est comparée, pour ce qui concerne la position de l'autre marquage secondaire (34a - 34e), avec une image de marquage idéale de consigne mise en mémoire.

7. Procédé selon la revendication 6, **caractérisé en ce que** comme premier marquage secondaire (32a - 32e), il est fourni un réticule (32a, 32e) à compléter dont les quadrants sont dotés progressivement par les étapes de revêtement d'autres marquages secondaires (34a, 34d) et/ou un arc de cercle (32b, 32c) qui est complété progressivement par les étapes de revêtement avec d'autres arcs de cercle (34b, 34c) pour former un cercle et/ou une trame avec plusieurs lignes parallèles qui sont dotées progressivement par les étapes de revêtement de lignes intermédiaires.

8. Procédé selon l'une des revendications précédentes, **caractérisé en ce qu'**un transfert de données continu de préférence notamment pour ce qui concerne la position et l'écart seuil entre les différentes étapes de procédé, en particulier entre les différentes étapes de revêtement, a lieu.

9. Procédé selon l'une des revendications précédentes, **caractérisé en ce que** l'écart seuil autorisé est ≤ 300 µm, en particulier ≤ 20 µm.

10. Procédé selon l'une des revendications précédentes, **caractérisé en ce qu'**en plus du système de détection optique du marquage, un contrôle qualité est exécuté avec un procédé non optique, en particulier capacitif et/ou magnétique.

11. Procédé selon l'une des revendications précédentes, **caractérisé en ce qu'**entre deux étapes de procédé a lieu une dépose mécanique du laminé piézoélectrique (13) et/ou du flan piézoélectrique (16) à partir d'une position de départ, suivie du traitement du laminé piézoélectrique (13) et/ou du flan piézoélectrique (16) dans une position de traitement éloignée de la position de départ ou orientée différemment par rapport à la position de départ, puis du retour à la position de départ, une orientation de la position par rapport au marquage de référence (30) étant effectuée.

12. Procédé selon l'une des revendications précédentes, **caractérisé en ce que** la séparation est réalisée au moyen d'une opération de sciage.

13. Procédé selon l'une des revendications précédentes, **caractérisé en ce que** le transducteur piézoélectrique est un transducteur à flexion piézoélectrique.

14. Dispositif de fabrication de transducteurs piézoélectriques, comprenant :
- un système de laminage (12) servant à laminer une unité de mise en contact (23) en forme de plaque équipée d'éléments de raccordement (26) en matériau conducteur électrique, et plusieurs couches piézoélectriques (22) attenantes à l'unité de mise en contact composée d'un matériau piézoélectrique avec une structure de départ de corps support (21) formant un laminé piézoélectrique (13),
- un système de revêtement (14) comprenant au moins une unité de revêtement (15) servant à revêtir le laminé piézoélectrique (13) en plusieurs étapes de revêtement avec différentes couches fonctionnelles, l'une d'entre elles au moins étant une couche d'électrodes (35) en matériau conducteur électrique devant être appliquée sur la couche piézoélectrique (22),
- un système de séparation (17) servant à séparer le flan piézoélectrique (16) pour former le transducteur piézoélectrique et
- un système de détection du marquage (18) comprenant une unité de détection (19) servant à détecter la position du laminé piézoélectrique (13) ou du flan piézoélectrique (16) en fonction d'une orientation par rapport à un marquage de référence (30) disposé au niveau de l'unité de mise en contact (23) et servant à détecter la position relative de marquages secondaires (32a - 32e, 34a - 34e) voisins disposés au niveau de l'unité de mise en contact (23) en tant que position réelle, et à comparer, au moyen d'une unité d'analyse (20), une position de consigne enregistrée dans l'unité avec la position réelle.
